# EUROPÄISCHE PATENTSCHRIFT

(11) **EP 2 803 110 B1**
(45) Veröffentlichungstag und Bekanntmachung des Hinweises auf die Patenterteilung: **07.09.2016**
(21) Anmeldenummer: 12809607.0
(22) Anmeldetag: 14.12.2012
(51) Int. Cl.: H01M 10/48, B60L 3/00, B60L 11/18, G01R 31/04, H01M 10/42, H01M 2/20, G01R 31/36, H04Q 9/00

(54) **BATTERIEANORDNUNG FÜR EIN KRAFTFAHRZEUG**
BATTERY ARRANGEMENT FOR A MOTOR VEHICLE
SYSTÈME DE BATTERIE POUR VÉHICULE À MOTEUR

(30) Priorität: 13.01.2012 DE 102012000585
(43) Veröffentlichungstag der Anmeldung: 19.11.2014
(73) Patentinhaber: Audi AG, 85045 Ingolstadt (DE)
(72) Erfinder: SCHMIDT, Jörg, 85057 Ingolstadt (DE); HINTERBERGER, Michael, 85055 Ingolstadt (DE); AVDIC, Reuf, 85055 Ingolstadt (DE); ACIKGOEZ, Erdal, 85084 Reichertshofen (DE); STÖCKERT, Diana, 85055 Ingolstadt (DE)
(74) Vertreter: Herbst, Matthias Heinz
(86) Internationale Anmeldenummer: PCT/EP2012/005164
(87) Internationale Veröffentlichungsnummer: WO 2013/104393

(56) Entgegenhaltungen:
- FR-A1- 2 589 008
- US-A1- 2010 052 428
- US-B1- 6 184 656

## Beschreibung

Die vorliegende Erfindung betrifft eine Batterieanordnung für ein Kraftfahrzeug mit einer Mehrzahl von Batteriemodulen. Überdies betrifft die vorliegende Erfindung ein Kraftfahrzeug. Schließlich betrifft die vorliegende Erfindung ein Verfahren zum Überprüfen einer elektrischen Verbindung zwischen zumindest zwei Batteriemodulen einer Batterieanordnung für ein Kraftfahrzeug.

In Kraftfahrzeugen werden Batterieanordnungen zur elektrischen Versorgung der Betriebskomponenten des Kraftfahrzeugs verwendet. Insbesondere in Elektrofahrzeugen werden Traktionsbatterien verwendet, die mehrere in Reihe geschaltete Batteriemodule umfassen, um eine entsprechend hohe Gesamtspannung zu erzielen, damit die geforderte Leistung übertragen werden kann. Diese Batteriemodule können eine Mehrzahl von Batteriezellen bzw. Einzelzellen umfassen, die beispielsweise aus Lithium-Ionen-Zellen oder Zellen mit einer anderen Zellen, beispielsweise eine Nickel-Metallhydrid-Akkumulator (NiMH), gebildet sein. Dabei werden in der Regel die Batteriezellen durch eine übergeordnete Überwachungseinrichtung bzw. ein Batteriemanagementsystem überwacht. Hierbei wird von jeder der Batteriezellen eine Messleitung bzw. Senseleitung in das Batteriemanagement geführt. Während des Aufbaus einer solchen Batterieanordnung kann man unter Zuhilfenahme dieser Messleitungen auch erkennen, welche elektrische Spannung im Gesamtsystem bereits erreicht wurde. Durch eine gezielte Einflussnahme auf die Montagereihenfolge ist es dann auch möglich, eine gefährliche Spannung, beispielsweise eine Gleichspannung über 60 V, so spät wie möglich zu erzielen.

Bekannt ist auch der Weg zur Modularisierung einer solchen Batterieanordnung. Dabei ist man bestrebt, die Auswertung der Zellspannungen auf Modulebene zu belassen. Die einzelnen Batteriemodule kommunizieren ihre Messwerte dann über ein entsprechendes Bussystem (z. B. CAN-Bus) an ein übergeordnetes Batteriemanagementsystem. Hierbei sind die einzelnen Batteriemodule jeweils mit einer entsprechenden Steuereinheit gekoppelt. Diese Steuereinheit kennt die elektrische Verschaltung und die von dem Batteriemodul bereitgestellte elektrische Spannung und gibt diese Informationen an die übergeordnete Überwachungseinrichtung bzw. das übergeordnete Batteriemanagementsystem weiter. Den jeweiligen Steuereinheiten der Batteriemodule liegt keine Information über die Verschaltung der Module untereinander vor. Ebenso liegen auch in dem übergeordneten Batteriemanagementsystem die Informationen die von der Batterieanordnung bereitgestellte elektrische Spannung erst nach dem Aufbau der Batterieanordnung vor. Dies hat zur Folge, dass die elektrische Spannung die an der Batterieanordnung anliegt, während des Aufbaus der Batterieanordnung nicht nachverfolgt werden kann. Damit kann auch eine mögliche Gefährdung während des Aufbaus der Batterieanordnung nicht ermittelt werden.

Die DE 198 10 746 B4 beschreibt eine Platine mit einer Schaltung zur Überwachung einer mehrzelligen Akkumulatorbatterie, mit der die elektrische Spannung und die Temperatur der einzelnen Zellen in der Batterie erfasst werden kann. Die Platine weist zudem Ein- und Ausgänge auf, die an einen Datenbus angeschlossen sind, der die Batterie mit weiteren Batterien und einem zentralen Batteriemanagementsystem verbindet.

Des Weiteren ist aus der DE 10 2008 058 924 B4 ein Verfahren zur Identifikation und Qualitätsdokumentation von Akkumulatoren für Industriewerkzeuge bekannt. Hierbei werden die Daten des Akkumulators, wie beispielsweise seine Seriennummer, in einem entsprechenden Baustein gespeichert. Diese Daten können auf die dem Akkumulator zugeordnete Stromleitung aufmoduliert werden.

Die DE 10 2010 016 175 A1 beschreibt eine Vorrichtung zur Überwachung und Steuerung einer Batterie, wobei jeder Batteriezelle in der Batterie ein Batterieüberwachungsmodul zugeordnet ist. Des Weiteren umfasst die Vorrichtung einen Systemcontroller, der dazu ausgebildet ist, die Batteriemodule zu überwachen, Daten von diesen abzurufen und Befehle zur Steuerung des Ladeausgleichs auszuführen.

Eine Batterie mit mehreren hintereinander geschalteten Einzelzellen, die über eine gemeinsame Stromleitung zum Laden der Einzelzellen miteinander verbunden sind, ist in der DE 195 45 833 B4 beschreiben. Hierbei ist jeder Einzelzelle der Batterie ein Einzelzellen-Modul zugeordnet, das die Möglichkeit besitzt, individuelle Ladesignale zu empfangen und umzusetzen. Die Abgabe der individuellen Ladesignale geschieht durch eine Zentraleinheit über die Stromleitung, die als modulierter Feldbus ausgebildet sein kann.

Zudem offenbart die DE 103 37 243 A1 ein Batterieprüfmodul für Akkumulatorbatterien, bei denen in einem Batteriegehäuse eine Mehrzahl von Batteriezellen in Reihe geschaltet sind. Mit dem Batterieprüfmodul können Informationen über die Beschaffenheit der Batterie bereitgestellt werden. Das Batterieprüfmodul ist dazu ausgebildet, Daten, wie beispielsweise die Seriennummer der Batterie, zu empfangen und zu übertragen. Diese Daten können auch an den positiven und negativen Anschlüssen der Batterie bereitgestellt werden.

Schließlich beschreibt die US 6,184,656 B1 eine Batterieanordnung mit einer Mehrzahl von Batteriemodulen, die jeweils mehrere Batteriezellen umfassen können. Dabei ist jedem Batteriemodul eine Steuereinheit zugeordnet. Jede der Steuereinheit ist dazu ausgebildet, über die elektrische Verbindungsleitung, mit denen die einzelnen Batteriemodule elektrisch verbunden sind, Daten zu senden und Daten von anderen Steuereinheiten zu empfangen. Mit den Steuereinheiten können auch Daten zu einer übergeordneten Überwachungseinrichtung gesendet werden.

Es ist Aufgabe der vorliegenden Erfindung einen Weg aufzuzeigen, wie der Aufbau einer Batterieanordnung für ein Kraftfahrzeug, die eine Mehrzahl von Batteriemodulen umfasst, auf einfache Weise sicher ausgeführt werden kann.

Diese Aufgabe wird erfindungsgemäß durch eine Batterieanordnung gemäß Patentanspruch 1, durch ein Kraftfahrzeug gemäß Patentanspruch 5 und durch ein Verfahren gemäß Patentanspruch 6 gelöst. Vorteilhafte Weiterbildungen der vorliegenden Erfindung sind in den Unteransprüchen angegeben.

Die erfindungsgemäße Batterieanordnung für ein Kraftfahrzeug umfasst eine Mehrzahl von Batteriemodulen, wobei jedes der Batteriemodule eine Mehrzahl von Batteriezellen umfasst, mit einer jeweiligen Steuereinheit gekoppelt ist und zwischen jeweils benachbarten Batteriemodulen eine Hochvoltleitung zum elektrisch Koppeln bereitgestellt ist, wobei die Steuereinheiten jeweils dazu ausgebildet sind, Daten über die Hochvoltleitung auszutauschen. Die Batterieanordnung wird beispielsweise als Traktionsbatterie in einem Kraftfahrzeug verwendet. Die Batterieanordnung umfasst eine Mehrzahl von Batteriemodulen, die elektrisch in Reihe geschaltet sind, um die in dem Kraftfahrzeug, insbesondere in einem Elektrofahrzeug, benötigte elektrische Leistung bereitzustellen. Jedes der Batteriemodule umfasst eine Mehrzahl von Batteriezellen, die elektrisch in Reihe geschaltet sein können. In der Batterieanordnung können jeweils zumindest zwei benachbarte Batteriemodule mit einer Hochvoltleitung elektrisch gekoppelt bzw. verbunden werden. Jede der Batteriezellen ist mit einer Steuereinheit gekoppelt, mit der üblicherweise die elektrischen Spannungen der Batteriezellen in dem Batteriemodul überwacht werden können. Die Steuereinheiten sind zusätzlich dazu ausgebildet, Daten über die Hochvoltleitung auszutauschen. Wenn beispielsweise zwei Batteriemodule mit der Hochvoltleitung elektrisch verbunden sind, können die Daten zwischen den Steuereinheiten, die jeweils mit den benachbarten Batteriemodulen gekoppelt sind, ausgetauscht werden. Jede der Steuereinheiten ist dazu ausgebildet, Daten über die Hochvoltleitung zu senden und Daten, die von den anderen Steuereinheiten über die Hochvoltleitung gesendet werden, zu empfangen. Somit können auf einfache Weise zwischen den Steuereinheiten elektrisch verbundener Batteriemoduledaten Daten ausgetauscht werden, ohne dass hierfür eine zusätzliche Datenleitung verwendet werden muss.

Zudem umfasst die Batterieanordnung eine Messeinrichtung, mit der anhand der an die Überwachungseinrichtung gesendeten Daten ein Vorhandensein einer elektrischen Verbindung über die Hochvoltleitung zwischen zumindest zwei der Batteriemodule bestimmbar ist. Die Daten, die an der Überwachungseinrichtung vorliegen, beinhalten Informationen, ob die Steuereinheiten jeweils Daten von den anderen Steuereinheiten empfangen haben und welche in anderen Steuereinheiten die jeweiligen Steuereinheiten Daten empfangen haben. Die Steuereinheiten können von den anderen Steuereinheiten nur Daten empfangen haben, wenn die Batteriemodule, mit denen die jeweiligen Steuereinheiten gekoppelt sind, elektrisch über die Hochvoltleitung verbunden sind. Anhand dieser Informationen kann ermittelt werden, welche der Batteriemodule elektrisch miteinander verbunden sind. Somit kann zudem auf die elektrische Spannung geschlossen werden, die in der Batterieanordnung durch die Reihenschaltung der einzelnen Batteriemodule vorliegt. Dies ermöglicht es beim Aufbau der Batterieanordnung ständig zu überwachen, welche Spannung momentan in der Batterieanordnung anliegt.

Des Weiteren ist mit der Messeinrichtung ein Warnsignal ausgebbar, falls die durch die elektrische Verbindung zwischen den zumindest zwei Batteriemodulen an der Hochvoltleitung bereitgestellte elektrische Gesamtspannung einen vorgegebenen Grenzwert überschreitet. Somit kann durch die Messeinrichtung beispielsweise ein Signal ausgegeben werden, falls die elektrische Spannung in der Batterieanordnung eine Gleichspannung von 60 V überschreitet. Infolgedessen können entsprechende Sicherheitsmaßnahmen berücksichtigt werden bzw. eine entsprechende Schutzkleidung vorgesehen werden. Somit ist ein besonders sicherer Aufbau einer Batterieanordnung für ein Kraftfahrzeug, insbesondere für ein Elektrofahrzeug, möglich.

Bevorzugt ist jede der Steuereinheiten dazu ausgebildet, Daten zu senden, die eine Kennung des Batteriemoduls enthält, mit dem sie gekoppelt ist. Eine solche Kennung kann beispielsweise eine entsprechende Identifikationsnummer des jeweiligen Batteriemoduls sein. Zudem sind die Steuereinheiten dazu ausgebildet, Daten von den anderen Steuereinheiten zu empfangen, die jeweils eine Kennung des Batteriemoduls enthält, mit dem die jeweilige Steuereinheit gekoppelt ist. Wenn die Batteriemodule untereinander mit der Hochvoltleitung verbunden sind, können auch Daten über die Hochvoltleitungen übertragen werden. Somit kann auf einfache Weise eine Kommunikation zwischen den einzelnen Batteriemodulen in der der Batterieanordnung ermöglicht werden.

In einer Ausführungsform modulieren die Steuereinheiten zum Austauschen der Daten eine von zumindest einem Batteriemodul an der Hochvoltleitung erzeugte Spannung. Auf die Hochvoltleitung, mit der zumindest zwei Batteriemodule in Reihe geschaltet sind, wird durch die Steuereinheiten jeweils ein entsprechendes Signal aufmoduliert, das eine Kennung enthält. Dies kann beispielsweise durch eine Pulsweitenmodulation der elektrischen Spannung bzw. des Spannungssignal erfolgen, das über die Hochvoltleitung übertragen wird. Zu diesem Zweck umfassen die Steuereinheiten jeweils eine entsprechende Elektronik, mit der in Modulation des Spannungssignals ermöglicht wird.

In einer Ausführungsform ist jede der Steuereinheiten zum Austauschen der Daten über eine Messleitung mit der Hochvoltleitung elektrisch verbunden, wobei die Steuereinheit an der Messleitung eine elektrische Spannung zumindest einer Batteriezelle des Batteriemoduls, mit dem sie gekoppelt ist, erfasst. Die Batteriezellen bzw. Einzelzellen in jedem Batteriemodul sind jeweils mit einer entsprechenden Messleitung bzw. Senseleitung mit der Steuereinheit verbunden. Somit kann die Steuereinheit die elektrische Spannung an den Einzelzellen überwachen. Nun werden bevorzugt die Messleitungen, die in Batteriezellen an den beiden Enden des Batteriemoduls angeordnet sind, mit der Hochvoltleitung verbunden, wenn die Hochvoltleitung an das jeweilige Batteriemodul elektrisch angeschlossen wird. Somit kann auf einfache Weise von der Steuereinheit über die Messleitung ein moduliertes Signal an die Hochvoltleitung übertragen werden. Ebenso kann über diese Messleitung von der Hochvoltleitung ein entsprechendes Signal an die Steuereinheit übermittelt werden.

In einer Ausgestaltung ist jede der Steuereinheiten dazu ausgebildet, die von den jeweils über die jeweilige Hochvoltleitung empfangenen Daten über einen Datenbus an eine übergeordnete Überwachungseinrichtung zu senden. Die Steuereinheiten der Batteriemodule in der Batterieanordnung sind alle über einen Datenbus, insbesondere den CAN-Bus, mit einer übergeordneten Überwachungseinrichtung bzw. dem Batteriemanagementsystem verbunden. Somit liegen in dem übergeordneten Batteriemanagementsystem Informationen vor, welche Steuereinheitsdaten von den anderen Steuereinheiten empfangen hat. Ein entsprechender Datenbus und eine übergeordnete Überwachungseinrichtung sind üblicherweise in Elektrofahrzeugen vorhanden, wodurch keine zusätzlichen Kosten entstehen.

Das erfindungsgemäße Kraftfahrzeug umfasst die zuvor beschriebene Batterieanordnung. Insbesondere ist das Kraftfahrzeug ein Elektrofahrzeug, bei dem die Batterieanordnung als Traktionsbatterie verwendet wird.

Das erfindungsgemäße Verfahren zum Überprüfen einer elektrischen Verbindung zwischen zumindest zwei Batteriemodulen einer Batterieanordnung für ein Kraftfahrzeug umfasst das Bereitstellen der Batteriemodule, wobei jedes der Batteriemodule eine Mehrzahl von Batteriezellen umfasst und jedes Batteriemodul mit einer jeweiligen Steuereinrichtung gekoppelt ist und das elektrische Verbinden von zumindest zwei benachbarten Batteriemodulen mit jeweils einer Hochvoltleitung, das Senden von Daten mit jeder der Steuereinheiten, wobei die Steuereinheiten dazu ausgebildet sind, Daten über die Hochvoltleitung zu übertragen, das Überprüfen einer elektrischen Verbindung zwischen zumindest zwei Batteriemodulen anhand der von den Steuereinheiten jeweils von den anderen Steuereinheiten empfangen Daten, und das Ausgeben eines Warnsignals, falls die durch die elektrische Verbindung zwischen den zumindest zwei Batteriemodulen bereitgestellte Spannung einen vorgegebenen Grenzwert überschreitet.

Die zuvor im Zusammenhang mit dem der erfindungsgemäßen Batterieanordnung beschriebenen Vorteile und Weiterbildungen können in gleicher Weise auf das erfindungsgemäße Kraftfahrzeug und das erfindungsgemäße Verfahren übertragen werden.

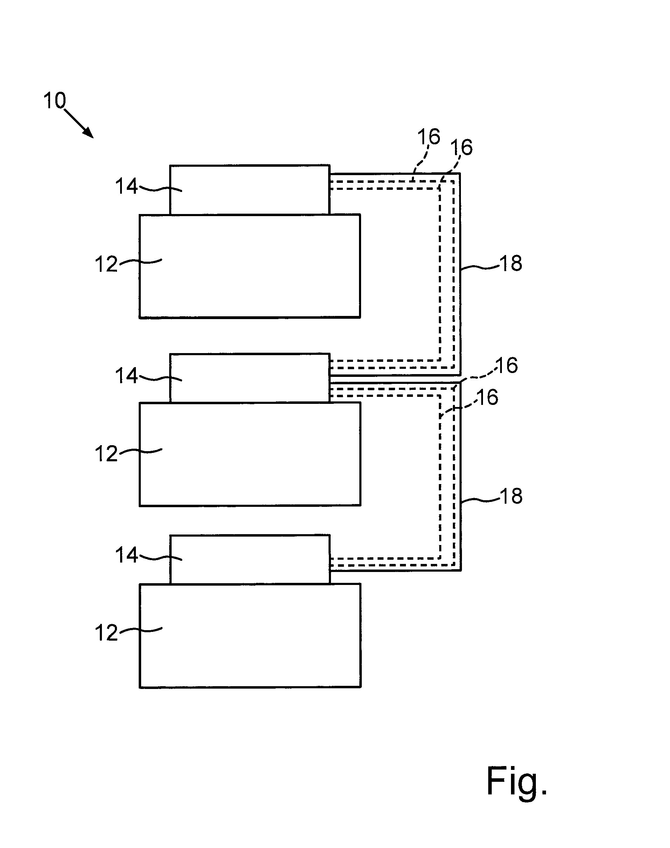

Die vorliegende Erfindung wird nun anhand der beigefügten Zeichnungen näher erläutert. Die einzige Figur zeigt dabei eine schematische Darstellung einer Batterieanordnung für ein Kraftfahrzeug.

Das nachfolgend näher geschilderte Ausführungsbeispiel stellt eine bevorzugte Ausführungsform der vorliegenden Erfindung dar.

Die Figur zeigt eine schematische Darstellung einer Batterieanordnung 10. Diese Batterieanordnung 10 kann in einem Kraftfahrzeug, insbesondere in einem Elektrofahrzeug verwendet werden. Insbesondere kann die Batterieanordnung 10 als Traktionsbatterie verwendet werden. Eine solche Batterieanordnung 10 umfasst üblicherweise eine Mehrzahl von Batteriemodulen 12 und der Figur ist eine Batterieanordnung 10 dargestellt, die drei Batteriemodule 12 umfasst.

Jedes der Batteriemodule umfasst eine Mehrzahl von Batteriezellen, die in der Figur nicht näher dargestellt sind. Diese Batteriezellen können Lithium-Ionen-Zellen oder Zellen mit einer andern Zellchemie sein. Die Batterien in den Batteriemodulen 12 sind üblicherweise elektrisch in Reihe geschaltet. Insbesondere umfasst das Batteriemodul 12 die gleiche Anzahl an Batteriezellen bzw. Einzelzellen.

Jedes der Batteriemodule 12 ist mit einer Steuereinheit 14 gekoppelt. Jede der Batteriezellen eines Batteriemoduls 12 kann mit einer entsprechenden Messleitung verbunden sein, die wiederum mit der jeweiligen Steuereinheit 14 elektrisch verbunden ist. Somit kann die Steuereinheit 14 beispielsweise die elektrische Spannung der einzelnen Batteriezellen in dem Batteriemodul 12 überwachen. Die einzelnen Steuereinheiten 14 der Batteriemodule 12 sind durch eine Datenleitung 16 untereinander verbunden. Diese Datenleitung kann beispielsweise der CAN-Bus sein. Die einzelnen Steuereinheiten 14 sind über die Datenleitung 16 mit einer hier nicht dargestellten übergeordneten Überwachungseinrichtung bzw. den Batteriemanagementsystem verbunden.

Während des Aufbaus der Batterieanordnung 10 können jeweils benachbarte Batteriemodule 12 mit einer Hochvoltleitung 18 elektrisch verbunden, insbesondere in Reihe geschaltet werden. Durch die elektrische Reihenschaltung der einzelnen Batteriemodule 12 über die jeweilige Hochvoltleitung 18 kann die in dem Kraftfahrzeug benötigte elektrische Spannung bzw. Leistung bereitgestellt werden.

Die Steuereinheiten 14 sind zusätzlich dazu ausgebildet, Daten über die Hochvoltleitung 18 auszutauschen. Jede der Steuereinheiten 14 kann Daten zu den anderen Steuereinheiten 14 senden und Daten, die von den anderen Steuereinheiten 14 über die Hochvoltleitung 18 gesendet werden, empfangen. Die Daten, wie es von einer der Steuereinheiten 14 gesendet wird, enthält bevorzugt eine Kennung des Batteriemoduls 12, mit dem Steuereinheit 14 gekoppelt ist. Der Datenaustausch zwischen zwei Steuereinheiten 14 wird erst ermöglicht, wenn die Batteriemodule 12, die den Steuereinheiten 14 zugeordnet sind, über die Hochvoltleitung 18 elektrisch miteinander verbunden sind.

Die übergeordnete Überwachungseinrichtung, mit der jede der Steuereinheiten 14 über den Datenbus 16 verbunden ist, kann entsprechende Daten von jeder der Steuereinheiten 14 empfangen, die Informationen darüber beinhalten, ob eine der Steuereinheiten 14 von zumindest einer weiteren Steuereinheit 14 Daten empfangen hat und von welchen Steuereinheiten 14 sie Daten empfangen hat. Diese auf der übergeordneten Überwachungseinrichtung bzw. dem Batteriemanagementsystem hinterlegte Information kann mit einer nicht dargestellten Messeinrichtung ausgewertet werden. Anhand der Informationen kann die Messeinrichtung bestimmen, welche der Steuereinheiten 14 jeweils Daten von den anderen Steuereinheiten 14 empfangen hat.

Da die Übertragung der Daten über die Hochvoltleitung 18 geschieht, kann die Messeinrichtung anhand dieser Informationen bestimmen, welche der Batteriemodule 12 jeweils über die Hochvoltleitung 18 elektrisch miteinander verbunden sind. Mit dieser Information und mit der zusätzlichen Information, welche elektrische Spannung von dem jeweiligen Batteriemodul 12 bereitgestellt wird, kann die Messeinrichtung die momentan der Batterieanordnung 10 vorliegende elektrische Spannung bestimmen. Zudem kann die Messeinrichtung ein entsprechendes Warnsignal ausgeben, falls die elektrische Spannung in der Batterieanordnung 10 einen vorgegebenen Grenzwert überschreitet. Somit kann eine hohe Sicherheit beim Aufbau einer Batterieanordnung 10 gewährleistet werden, die eine Mehrzahl von Batteriemodulen 12 umfasst.

## Patentansprüche

1. Batterieanordnung (10) für ein Kraftfahrzeug mit einer Mehrzahl von Batteriemodulen (12), wobei jedes der Batteriemodule (12)
- eine Mehrzahl von Batteriezellen umfasst,
- mit einer jeweiligen Steuereinheit (14) gekoppelt ist, und
- zwischen jeweils benachbarten Batteriemodulen (12) eine Hochvoltleitung (18) zum elektrisch Koppeln bereitgestellt ist, wobei
- die Steuereinheiten (14) jeweils dazu ausgebildet sind, Daten über die Hochvoltleitung (18) auszutauschen, und die über die jeweiligen Hochvoltleitungen (18) empfangenen Daten über einen Datenbus (16) an eine übergeordnete Überwachungseinrichtung zu senden,
**dadurch gekennzeichnet, dass**
- die Batterieanordnung (10) eine Messeinrichtung umfasst, mit der anhand der an die Überwachungseinrichtung gesendeten Daten ein Vorhandensein einer elektrischen Verbindung über die Hochvoltleitung (18) zwischen zumindest zwei der Batteriemodule (12) bestimmbar ist, und
- mit der Messeinrichtung ein Warnsignal ausgebbar ist, falls die durch die elektrische Verbindung zwischen den zumindest zwei Batteriemodulen (12) bereitgestellte elektrische Gesamtspannung einen vorgegebenen Grenzwert überschreitet.

2. Batterieanordnung (10) nach Anspruch 1,
**dadurch gekennzeichnet, dass**
jede der Steuereinheiten (14) dazu ausgebildet ist, Daten zu senden, die eine Kennung des Batteriemoduls (12) enthält, mit dem sie gekoppelt ist.

3. Batterieanordnung (10) nach Anspruch 1 oder 2,
**dadurch gekennzeichnet, dass**
die Steuereinheiten (14) zum Austauschen der Daten eine von zumindest einem Batteriemodul (12) an der Hochvoltleitung (18) erzeugte Spannung zu modulieren.

4. Batterieanordnung (10) nach einem der vorhergehenden Ansprüche,
**dadurch gekennzeichnet, dass**
jede Steuereinheit (14) zum Austauschen der Daten über eine Messleitung mit der Hochvoltleitung (18) elektrisch verbunden ist, wobei die Steuereinheit (14) an der Messleitung eine elektrische Spannung zumindest einer Batteriezelle des Batteriemoduls (12), mit dem sie gekoppelt ist, erfasst.

5. Kraftfahrzeug mit einer Batterieanordnung (10) nach einem der vorhergehenden Ansprüche.

6. Verfahren zum Überprüfen einer elektrischen Verbindung zwischen zumindest zwei Batteriemodulen (12) einer Batterieanordnung (10) für ein Kraftfahrzeug, durch
- Bereitstellen der Batteriemodule (12), wobei jedes der Batteriemodule (12) eine Mehrzahl von Batteriezellen umfasst und jedes Batteriemodul (12) mit einer jeweiligen Steuereinrichtung (14) gekoppelt ist,
- Elektrisches Verbinden von zumindest zwei benachbarten Batteriemodulen mit einer Hochvoltleitung (14), und
- Senden von Daten mit jeder der Steuereinheiten (14), wobei die Steuereinheiten (14) dazu ausgebildet sind, Daten über die Hochvoltleitung (18) zu übertragen,
**gekennzeichnet durch**
- Überprüfen einer elektrischen Verbindung zwischen zumindest zwei Batteriemodulen (12) anhand der von den Steuereinheiten (14) jeweils von den anderen Steuereinheiten (14) empfangenen Daten, und
- Ausgeben eines Warnsignals, falls die **durch** die elektrische Verbindung zwischen den zumindest zwei Batteriemodulen (12) bereitgestellte elektrische Gesamtspannung einen vorgegebenen Grenzwert überschreitet.

## Claims

1. Battery arrangement (10) for a motor vehicle, comprising a plurality of battery modules (12), each of the battery modules (12)
- comprising a plurality of battery cells,
- being coupled to a respective control unit (14), and
- a high voltage lead (18) being provided for electrical coupling between respectively adjacent battery modules (12),
- the control units (14) being configured to exchange data via the high voltage lead (18), and to transmit the data received via the respective high voltage leads (18) to a higher-level monitoring device via a data bus (16),
**characterized in that**
- the battery arrangement (10) comprises a measuring device configured to determine, on the basis of the data transmitted to the monitoring device, the presence of an electrical connection via the high voltage lead (18) between at least two of the battery modules (12), and
- the measuring device is configured to generate a warning signal in the event that the total electrical voltage provided by the electrical connection between the at least two battery modules (12) exceeds a predetermined threshold.

2. Battery arrangement (10) according to claim 1,
**characterized in that**
each of the control units (14) is configured to transmit data comprising an identifier of the battery module (12) to which it is coupled.

3. Battery arrangement (10) according to claim 1 or 2,
**characterized in that**
the control units (14) for exchanging data modulate a voltage generated by at least one battery module (12) at the high voltage lead (18).

4. Battery arrangement (10) according to any of the preceding claims, **characterized in that**
each control unit (14) is electrically connected to the high voltage lead (18) via a measuring lead for exchanging data , the control unit (14) detecting at the measuring lead an electrical voltage of at least one battery cell of the battery module (12) to which it is coupled.

5. Motor vehicle comprising a battery arrangement (10) according to any of the preceding claims.

6. Method for checking an electrical connection between at least two battery modules (12) of a battery arrangement (10) for a motor vehicle, comprising:
- providing the battery modules (12), wherein each of the battery modules (12) comprises a plurality of battery cells and each battery module (12) is coupled to a respective control unit (14),
- electrically connecting at least two adjacent battery modules with a high voltage lead (14), and
- transmitting data from each of the control units (14), the control units (14) being configured to transmit data via the high voltage lead (18),
**characterized in that**
- an electrical connection between at least two battery modules (12) is checked on the basis of data received by each control unit (14) from the other control units (14), and
- a warning signal is generated in the event that the total electrical voltage provided by the electrical connection between the at least two battery modules (12) exceeds a predetermined threshold.

## Revendications

1. Système de batterie (10) pour un véhicule automobile avec une multiplicité de modules de batterie (12), dans lequel chacun des modules de batterie (12)
- comprend une multiplicité de cellules de batterie, et
- est relié à une unité de commande (14) respective,
- une ligne à haute tension (18) étant prévue pour la liaison électrique entre des modules de batterie (12) respectivement voisins, et
- les unités de commande (14) étant conçues à chaque fois pour échanger des données par l'intermédiaire de la ligne à haute tension (18) et pour envoyer les données reçues par l'intermédiaire des lignes à haute tension (18) respectives à un dispositif de contrôle de rang supérieur par l'intermédiaire d'un bus de données (16),
**caractérisé en ce que**
- le système de batterie (10) comprend un dispositif de mesure avec lequel on peut déterminer à l'aide des données envoyées au dispositif de contrôle l'existence d'une liaison électrique par l'intermédiaire de la ligne à haute tension (18) entre au moins deux des modules de batterie (12), et
- on peut fournir un signal d'avertissement avec le dispositif de mesure si la tension électrique totale fournie par la liaison électrique entre les au moins deux modules de batterie (12) dépasse une valeur limite prédéterminée.

2. Système de batterie (10) selon la revendication 1, **caractérisé en ce que** chacune des unités de commande (14) est conçue pour envoyer des données qui contiennent un identificateur du module de batterie (12) avec lequel elle est reliée.

3. Système de batterie (10) selon la revendication 1 ou 2, **caractérisé en ce que**, pour l'échange des données, les unités de commande (14) modulent une tension produite par au moins un module de batterie (12) sur la ligne à haute tension (18).

4. Système de batterie (10) selon l'une des revendications précédentes, **caractérisé en ce que**, pour l'échange des données, chaque unité de commande (14) est reliée électriquement à la ligne à haute tension (18) par l'intermédiaire d'une ligne de mesure, l'unité de commande (14) détectant sur la ligne de mesure une tension électrique d'au moins une cellule de batterie (12) à laquelle elle est reliée.

5. Véhicule automobile avec un système de batterie (10) selon l'une des revendications précédentes.

6. Procédé pour la vérification d'une liaison électrique entre au moins deux modules de batterie (12) d'un système de batterie (10) pour un véhicule automobile par
- la fourniture des modules de batterie (12), chacun des modules de batterie (12) comprenant une multiplicité de cellules de batterie et chaque module de batterie (12) étant relié à un dispositif de commande (14) respectif,
- la liaison électrique d'au moins deux modules de batterie voisins avec une ligne à haute tension (14), et
- l'envoi de données avec chacune des unités de commande (14), les unités de commande (14) étant conçues pour transmettre des données par l'intermédiaire de la ligne à haute tension (18),
**caractérisé par**
- la vérification d'une liaison électrique entre au moins deux modules de batterie (12) à l'aide des données reçues par les unités de commande (14) à chaque fois en provenance des autres unités de commande (14), et
- la fourniture d'un signal d'avertissement si la tension électrique totale fournie par la liaison électrique entre les au moins deux modules de batterie (12) dépasse une valeur limite prédéterminée.
